# EUROPÄISCHE PATENTSCHRIFT

(11) **EP 0 746 092 B1**
(45) Veröffentlichungstag und Bekanntmachung des Hinweises auf die Patenterteilung: **04.09.2002**
(21) Anmeldenummer: 96201442.9
(22) Anmeldetag: 24.05.1996
(51) Int. Cl.: H03B 5/12

(54) **Oszillator**
Oscillator
Oscillateur

(30) Priorität: 02.06.1995 DE 19520244
(43) Veröffentlichungstag der Anmeldung: 04.12.1996
(73) Patentinhaber: Philips Corporate Intellectual Property GmbH, 52064 Aachen (DE); Koninklijke Philips Electronics N.V., 5621 BA Eindhoven (NL)
(72) Erfinder: Brilka, Joachim, c/o Philips Patentverwaltung GmbH, 22335 Hamburg (DE)
(74) Vertreter: Peters, Carl Heinrich, Dipl.-Ing.

(56) Entgegenhaltungen:
- DE-A- 4 314 424
- US-A- 3 813 615

## Beschreibung

Die Erfindung bezieht sich auf einen Oszillator mit für eine erste Schwingfrequenz vorgesehenen ersten frequenzbestimmenden Elementen, mit wenigstens einem zweiten frequenzbestimmenden Element, welches zum Einstellen des Oszillators auf eine zweite Schwingfrequenz den ersten frequenzbestimmenden Elementen über wenigstens eine Schaltdiode zuschaltbar ist, mit einer Speiseschaltung, die wenigstens eine steuerbare Stromquelle umfaßt, durch die die Schaltdiode gespeist wird und durch deren Umsteuern sie wahlweise in den leitenden oder gesperrten Zustand schaltbar ist, und mit einer den Oszillator speisenden Stromquelle.

Ein derartiger Oszillator ist aus der DE-OS 43 14 424 bekannt. Dieser Oszillator ist bei einfachem Aufbau für mehrere Schwingfrequenzen umschaltbar und abstimmbar.

Insbesondere bei der Integration eines derartigen Oszillators auf einem Halbleiterköper ist es aus Gründen der preiswerten Herstellbarkeit zweckmäßig, als Schaltdiode einen Transistor, insbesondere einen Hochfrequenz-Transistor, zu verwenden, dessen Basisanschluß und dessen Kollektoranschluß miteinander verbunden sind. Es zeigt sich jedoch, daß eine derartig aufgebaute Schaltdiode eine verhältnismäßig hohe Impedanz auch im leitenden Zustand aufweist. Andere konstruktive Lösungen für den Aufbau der Schaltdiode haben sich als entweder zu kostspielig oder mit anderen Nachteilen behaftet erwiesen, beispielsweise durch parasitäre Transistorstrukturen mit unzulässig hohem Substratstrom, der wiederum die Betriebsbedingungen, insbesondere den Arbeitspunkt, des Oszillators unkontrolliert beeinflussen würde.

Die Erfindung hat die Aufgabe, einen Oszillator der eingangs genannten Art in der Weise zu verbessern, daß auch eine Schaltdiode mit relativ hoher Impedanz im leitenden Zustand eingesetzt werden kann, ohne daß dies zu merkbaren Beeinträchtigungen der Funktionstüchtigkeit des Oszillators führt.

Diese Aufgabe wird bei einem Oszillator der eingangs genannten Art erfindungsgemäß dadurch gelöst, daß die den Oszillator speisende Stromquelle von der Speiseschaltung zusammen mit dem Umsteuern der steuerbaren Stromquelle auf einen Speisestrom umsteuerbar ist, der derart zu einem von der steuerbaren Stromquelle abgebenen Strom dimensioniert ist, daß Beeinflussungen des Arbeitspunktes und der Schwingungsamplitude des Oszillators durch das Zuschalten des zweiten frequenzbestimmenden Elements wenigstens weitgehend ausgeglichen sind.

Durch die relativ hohe Impedanz der Schaltdiode im leitenden Zustand wird der Oszillator in dem Betriebsfall, in dem er durch Zuschalten des zweiten frequenzbestimmenden Elements auf der zweiten Schwingfrequenz arbeitet, stärker bedämpft als in dem Betriebsfall, in dem er nur mit den ersten frequenzbestimmenden Elementen auf der ersten Schwingfrequenz betrieben wird. Zum Ausgleich dieser Dämpfung kann zwar der von der den Oszillator speisenden steuerbaren Stromquelle (4) abgebbare Strom im leitenden Zustand der Schaltdiode entsprechend angepaßt werden, es zeigt sich jedoch, daß dies zu einer Arbeitspunktverschiebung des Oszillators führen kann. Zum Ausgleich dieser Beeinflussung des Arbeitspunktes bei gleichzeitigem Ausgleich der Beeinflussung der Schwingungsamplitude des Oszillators wird daher erfindungsgemäß auch der von der steuerbaren Stromquelle gelieferte Strom entsprechend umgesteuert.

Durch die Erfindung ist daher gewährleistet, daß mit einem einfachen Aufbau des Oszillators und damit einhergehendem Einsatz von Schaltdioden mit an sich ungünstigen Impedanzwerten trotzdem ein gleichmäßig gutes Betriebsverhalten erzielt wird. Insbesondere kann als Schaltdiode ein einfacher, zwischen Basis und Kollektor kurzgeschlossener Hochfrequenz-Transistor verwendet werden, der einfach mit der übrigen Schaltung zusammen integrierbar ist.

Ein erfindungsgemäßer Oszillator, der eine Differenzverstärkerstufe umfaßt aus zwei Transistoren, die mit ihren Emitteranschlüssen gemeinsam über die den Oszillator speisende Stromquelle mit Masse verbunden sind, wobei Kollektoranschlüsse der Transistoren über je einen Kollektorwiderstand mit einem Versorgungsspannungsanschluß verbunden sind, ist vorteilhaft dadurch weitergebildet, daß das Umsteuern der den Oszillator speisenden Stromquelle in der Weise erfolgt, daß in den Kollektorwiderständen in beiden Schaltzuständen der Schaltdiode übereinstimmende Ströme fließen. Dadurch wird in einfacher Weise erreicht, daß beim Zuschalten des zweiten frequenzbestimmenden Elements der Arbeitspunkt des Oszillators unverändert bleibt, da sich die Potentialverhältnisse an den Kollektorwiderständen nicht ändern.

Weitere Ausgestaltungen der Erfindung ergeben sich aus den Unteransprüchen.

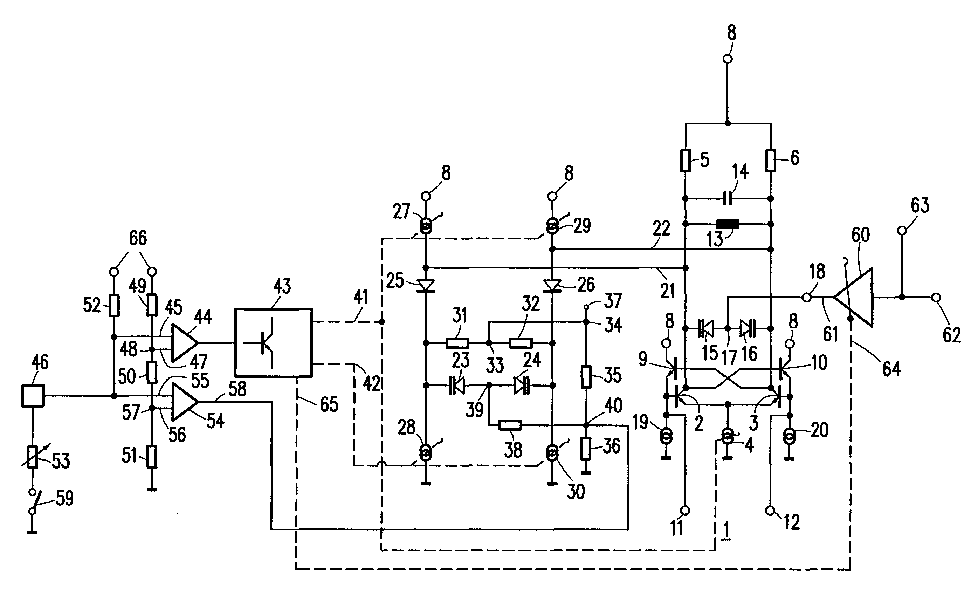

Ein Ausführungsbeispiel der Erfindung ist in der Zeichnung dargestellt und wird im nachfolgenden näher beschrieben. Ein Oszillator 1 umfaßt eine Differenzverstärkerstufe aus zwei Transistoren 2, 3, die mit ihren Emitteranschlüssen gemeinsam über eine Stromquelle 4 mit Masse verbunden sind. Die Kollektoranschlüsse der Transistoren 2, 3 sind über je einen Kollektorwiderstand 5, 6 mit einem Versorgungsspannungsanschluß 8 verbunden. Jeder der Kollektoranschlüsse der Transistoren 2 bzw. 3 ist mit dem Basisanschluß eines Emitterfolgertransistors 9 bzw. 10 verbunden, deren Kollektoranschlüsse am Versorgungsspannungsanschluß 8 liegen und deren Emitteranschlüsse mit Ausgangsanschlüssen 11, 12 verbunden sind. Von jedem der Emitterfolgertransistoren 9 bzw. 10 ist über dessen Emitteranschluß eine Verbindung an den Basisanschluß eines der Transistoren 2, 3 der Differenzverstärkerstufe hergestellt in der Weise, daß über jeden der Emitterfolgertransistoren 9 bzw. 10 der Kollektoranschluß eines der Transistoren 2 bzw. 3 mit dem Basisanschluß des jeweils anderen Transistors 3 bzw. 2 der Differenzverstärkerstufe gekoppelt ist. Auf diese Weise wird eine Mitkopplung erzielt. Die für eine erste Schwingfrequenz maßgeblichen ersten frequenzbestimmenden Elemente sind zwischen den Kollektoranschlüssen der Transistoren 2, 3 der Differenzverstärkerstufe angeschlossen und umfassen eine Induktivität 13, eine Kapazität 14 sowie als abstimmbares Element die gegensinnige Reihenschaltung zweier Kapazitätsdioden 15, 16, deren Verbindungspunkt 17 an einen Steuerspannungsanschluß 18 geführt ist, über den den Kapazitätsdioden 15, 16 eine Sperrvorspannung aufgeprägt werden kann. Damit ist über den Steuerspannungsanschluß 18 ein Abgleich des Oszillators 1 auf die erste Schwingfrequenz möglich.

Zur Speisung der Emitterfolgertransistoren 9, 10 sind deren Emitteranschlüsse mit Stromquellen 19 bzw. 20 verbunden, die gegen Masse geschaltet sind.

Über den Steuerspannungsanschluß 18 kann der Oszillator 1 auch als spannungsgesteuerter Oszillator betrieben werden, z.B. beim Einsatz in einer phasenverriegelten Regelschleife.

Zum Umschalten des Oszillators 1 auf eine zweite Schwingfrequenz ist dem ersten frequenzbestimmenden Element 13 bis 16 über Verbindungen 21, 22 ein zweites frequenzbestimmendes Element parallel geschaltet, welches aus zwei gegensinnig in Reihe geschalteten Kapazitätsdioden 23, 24 besteht. Das zweite frequenzbestimmende Element 23, 24 ist über je eine Schaltdiode 25, 26 an die Verbindungen 21 bzw. 22 angeschlossen. In Reihe mit jeder der Schaltdioden 25, 26 sind je zwei steuerbare Stromquellen 27, 28 bzw. 29, 30 zwischen den Versorgungsspannungsanschluß 8 und Masse geschaltet. Dies ist in der Weise vorgenommen, daß je eine der Stromquellen mit je einem ihrer Anschlüsse an einen der Verbindungspunkte zwischen der Verbindung 21 und der ersten Schaltdiode 25, zwischen der Verbindung 22 und der zweiten Schaltdiode 26, zwischen der ersten Schaltdiode 25 und der ersten Kapazitätsdiode 23 des zweiten frequenzbestimmenden Elements bzw. zwischen der zweiten Schaltdiode 26 und der zweiten Kapazitätsdiode 24 des zweiten frequenzbestimmenden Elements angeschlossen sind, während je ein weiterer Anschluß der Stromquellen 27 bis 30 entweder mit dem Versorgungsspannungsanschluß 8 oder Masse verbunden ist. Somit wird die erste Schaltdiode 25 durch die steuerbaren Stromquellen 27 und 28, die zweite Schaltdiode 26 durch die steuerbaren Stromquellen 29 und 30 gespeist. Durch Umsteuern bzw. Ein- und Ausschalten der steuerbaren Stromquellen 27 bis 30 kann den Schaltdioden 25, 26 entweder ein Gleichstrom aufgeprägt werden, durch den sie in den leitenden Zustand geschaltet werden, oder es können die steuerbaren Stromquellen 27 bis 30 stromlos geschaltet werden, so daß auch die Schaltdioden 25, 26 gesperrt werden. Im ersteren Fall ist das zweite frequenzbestimmende Element 23, 24 parallel zu dem ersten frequenzbestimmenden Element 13 bis 16 geschaltet, im zweiten Fall ist diese Verbindung unterbrochen, und der Oszillator 1 arbeitet auf der ersten Schwingfrequenz.

Parallel zu der Reihenschaltung der Kapazitätsdioden 23, 24 ist eine Reihenschaltung zweier Widerstände 31, 32 angeordnet, deren Verbindungspunkt 33 mit einem weiteren Referenzspannungsanschluß 37 verbunden ist. Ein Widerstands-Spannungsteiler aus zwei Widerständen 35 und 36 ist zwischen dem Referenzspannungsanschluß 37 und Masse angeordnet. Ein weiterer Widerstand 38 ist einerseits mit dem Verbindungspunkt 39 zwischen den Kapazitätsdioden 23 und 24 und andererseits mit einer Anzapfung 40 des Widerstands-Spannungsteilers 35, 36 verbunden, die durch den Verbindungspunkt der beiden Widerstände 35 und 36 gebildet wird. Über den Widerstands-Spannungsteiler 35, 36 sowie die Widerstände 31, 32, 38 werden einerseits die Kapazitätsdioden 23, 24 in Sperrichtung vorgespannt; andererseits ist die Schaltungsanordnung derart dimensioniert, daß bei abgeschalteten Stromquellen 27 bis 30 die Schaltdioden 25, 26 zuverlässig in den gesperrten Zustand überführt sind.

In vorteilhafter Weise sind die steuerbaren Stromquellen 27 bis 30 in einer gemeinsamen Stromspiegelanordnung miteinander verbunden. Dazu enthält jede der steuerbaren Stromquellen 27 bis 30 wenigstens einen Stromquellentransistor, und die Steueranschlüsse dieser Stromquellentransistoren sind gemäß den in der Figur durch gestrichelte Linien wiedergegebenen Wirkverbindungen 41 bzw. 42 paarweise miteinander verknüpft. Insbesondere werden die mit dem Versorgungsspannungsanschluß 8 verbundenen Stromquellen 27, 29 einerseits und die mit Masse verbundenen Stromquellen 28, 30 andererseits jeweils gemeinsam durch die Wirkverbindung 41 bzw. 42 gesteuert, vorzugsweise durch unmittelbare Verbindung der Steueranschlüsse der in ihnen vorhandenen Stromquellentransistoren. Eine Stromsteuerschaltung 43 umfaßt dabei vorzugsweise einen Stromspiegel, durch den die Wirkverbindungen 41 und 42 gemeinsam gesteuert werden. Der Eingangs- bzw. Primärzweig dieses Stromspiegels in der Stromsteuerschaltung 43 ist über einen Schalttransistor abschalt- bzw. überbrückbar und damit wahlweise in einen stromlosen Zustand überführbar, wodurch dann über die Wirkverbindungen 41, 42 auch die steuerbaren Stromquellen 27 bis 30 stromlos geschaltet werden. Dieser Schalttransistor ist symbolisch innerhalb des die Stromsteuerschaltung 43 repräsentierenden Schaltungsblocks dargestellt.

Die Wirkverbindung 41 ist weiterhin an die den Oszillator 1 speisende Stromquelle 4 geführt. Dadurch kann von der Stromsteuerschaltung 43 die Stromquelle 4 gemeinsam mit den steuerbaren Stromquellen 27 und 29 beim Zuschalten des zweiten frequenzbestimmenden Elements 23, 24 umgesteuert werden. Diese Umsteuerung wird in der Weise vorgenommen, daß für den Fall der Umschaltung des Oszillators 1 auf die zweite (tiefere) Schwingfrequenz, d.h. wenn die Schaltdioden 25, 26 in ihren leitenden Zustand überführt sind, der von der Stromquelle 4 abgegebene Speisestrom gegenüber dem Betriebszustand mit gesperrten Schaltdioden 25, 26 erhöht wird. Diese Erhöhung des Speisestromes in der Stromquelle 4 ist gerade gleich der Summe der Differenzen der Ströme der steuerbaren Stromquellen 27 und 28 bzw. 29 und 30. Die steuerbaren Stromquellen 27, 29 liefern somit zusätzlich zu den durch die steuerbaren Stromquellen 28, 30 geführten Ströme noch den Stromanteil, um den der Speisestrom der Stromquelle 4 erhöht wurde. Damit ist sichergestellt, daß der Strom durch die Kollektorwiderstände 5, 6 beim Zuschalten des zweiten frequenzbestimmenden Elements 23, 24 unverändert und damit der Arbeitspunkt des Oszillators 1 und somit der Kapazitätsdioden 15, 16 im Oszillator 1 konstant bleibt.

Die Stromsteuerschaltung 43 wird durch eine erste Treiberstufe 44 gesteuert, von der im wesentlichen der Schalttransistor innerhalb der Stromsteuerschaltung 43 betätigt wird. Die erste Treiberstufe 44 umfaßt insbesondere einen Differenzverstärker, dessen erster Eingang 45 mit einem Steuersignalanschluß 46 und dessen zweiter Eingang 47 mit einer ersten Anzapfung 48 eines zwischen eines weiteren Referenzspannungsanschluß 66 und Masse geschalteten, zweiten Widerstandsteilers aus drei Widerständen 49, 50, 51 verbunden ist. Durch den zweiten Widerstands-Spannungsteiler 49, 50, 51 wird an dessen erster Anzapfung 48 ein Schwellenwert bereitgestellt, bei dessen Über- bzw. Unterschreiten durch das Steuersignal am Steuersignalanschluß 46 das Umsteuern der steuerbaren Stromquellen 27 bis 30 und damit das Zu- bzw. Abschalten des zweiten frequenzbestimmenden Elements 23, 24 vorgenommen wird. In der Figur erfolgt die Bereitstellung des Steuersignals am Steuersignalanschluß 46 über einen weiteren Spannungsteiler aus einem vom Steuersignalanschluß 46 an den Referenzspannungsanschluß 66 gelegten Widerstand 52 und einem vom Steuersignalanschluß 46 an Masse gelegten, veränderbaren Widerstand 53. Dabei kann vorzugsweise die Verbindung zwischen dem Widerstand 53 und Masse durch eine Schaltvorrichtung 59 unterbrechbar sein. Insbesondere kann die gesamte, bisher beschriebene Schaltungsanordnung auf einem Halbleiterkörper zusammengefaßt sein, und der Steuersignalanschluß 46 kann bevorzugt ein externer Anschluß der so gebildeten, integrierten Schaltungsanordnung sein. Der veränderbare Widerstand 53 kann dann beispielsweise durch einen Steuertransistor oder ein Potentiometer gebildet werden.

Bei der erfindungsgemäßen Schaltungsanordnung wird jedoch vorteilhaft über den Steuersignalanschluß 46 mit der Zu- bzw. Abschaltung des zweiten frequenzbestimmenden Elements auch dessen Abstimmung auf die gewünschte, zweite Schwingfrequenz des Oszillators 1 vorgenommen. Dazu ist eine zweite Treiberstufe 54 vorgesehen, deren erster Eingang 55 ebenfalls mit dem Steuersignalanschluß 46 und dessen zweiter Eingang 56 mit einer zweiten Anzapfung 57 des zweiten Widerstands-Spannungsteilers 49 bis 51 verbunden ist. Diese zweite Treiberstufe 54 ist mit ihrem Ausgang 58 mit der zweiten Anzapfung 40 des Widerstands-Spannungsteilers 35, 36 verbunden.

Der durch die Spannung an der zweiten Anzapfung 57 gegebene Schwellenwert für die zweite Treiberstufe 54 ist gegenüber dem von der ersten Anzapfung 48 abgegriffenen Schwellenwert für die erste Treiberstufe 44 derart bemessen, daß der Schwellenwert an der ersten Treiberstufe 44 einen Aussteuerungsbereich der zweiten Treiberstufe 54 begrenzt, der durch den Schwellenwert an dieser zweiten Treiberstufe 54 festgelegt ist. Vorzugsweise umfaßt auch die zweite Treiberstufe 54 einen Differenzverstärker, und der Aussteuerungsbereich der Spannung zwischen den Eingängen 55 und 56, innerhalb dessen diese in linearem Zusammenhang mit einem dadurch ausgelösten Signal am Ausgang 58 steht, ist durch Wahl des Schwellenwertes an der zweiten Anzapfung 57 auf einen derartigen Pegel gebracht, daß bei Erreichen eines (vorzugsweise des oberen) Randes dieses Aussteuerungsbereiches das Steuersignal am Steuersignalanschluß 46 den Schwellenwert am ersten Eingang 45 der ersten Treiberstufe 44 erreicht und damit das zweite frequenzbestimmende Element 23, 24 abgeschaltet wird. Im genannten Aussteuerungsbereich wird dann von der zweiten Treiberstufe 54 der Vorspannung des zweiten frequenzbestimmenden Elements 23, 24 an der zweiten Anzapfung 40 eine Stellspannung zum Verändern der Kapazitätswerte der Kapazitätsdioden 23, 24 überlagert.

Im Ausführungsbeispiel nach der Figur wurden der Einfachheit halber die Kollektorwiderstände 5, 6, die Stromquellen 27 und 29 sowie die Kollektoranschlüsse der Emitterfolgertransistoren 9, 10 an denselben Versorgungsspannungsanschluß 8 gelegt. Je nach den erforderlichen Potentialen können hierfür auch unterschiedliche Versorgungsspannungsanschlüsse vorgesehen sein.

In einem Dimensionierungsbeispiel des erfindungsgemäßen Oszillators eingesetzt in einer Fernseh-ZF-PLL Schaltung zum Umschalten zwischen den französischen Videosignal-Übertragungsnormen L und L' beträgt die erste Schwingfrequenz das Doppelte der Bildträgerfrequenz von 38,9 MHz für die Übertragungsnorm L und die zweite Schwingfrequenz das Doppelte der Bildträgerfrequenz von 33,9 MHz für die Übertragungsnorm L'. Das zweite frequenzbestimmende Element 23, 24 wird beim Einstellen des Oszillators auf die Übertragungsnorm L' durch Schließen der Schaltvorrichtung 59 zugeschaltet. Über den veränderbaren Widerstand 53, die zweite Treiberstufe 54 und die Variation der Kapazitätswerte der Kapazitätsdioden 23, 24 läßt sich für den Oszillator 1 mit zugeschaltetem zweitem frequenzbestimmendem Element ein Stellumfang von etwa 1,2 MHz erreichen. Der erfindungsgemäße Oszillator weist außerdem eine niedrige Variation der Schwingfrequenz über der Betriebstemperatur und der Betriebsspannung auf.

Beim Abgleich eines Oszillators, wie er im vorstehenden beschrieben ist, über den Steuerspannungsanschluß 18 zeigt sich, daß die Steilheit der Abgleichkennlinie, d.h. die Abhängigkeit der Änderung der Schwingfrequenz von der Änderung der Sperrvorspannung am Steuerspannungsanschluß 18 beim Einstellen auf die unterschiedlichen Schwingfrequenzen verändert wird. Diese Veränderung der Steilheit beruht auf den unterschiedlichen Werten der frequenzbestimmenden Elemente, vorzugsweise der Kapazitätsdioden, für die unterschiedlichen Schwingfrequenzen. Insbesondere bei einem Einsatz des beschriebenen Oszillators in einer phasenverriegelten Regelschleife wirken sich die unterschiedlichen Steilheiten in einer Veränderung des Regelverhaltens der Regelschleife zwischen den unterschiedlichen Schwingfrequenzen aus.

Dieser Erscheinung kann durch ein Verstärkungselement 60 begegnet werden, dessen Verstärkungsfaktor gemeinsam mit dem Zuschalten wenigstens eines der zweiten frequenzbestimmenden Elemente 23, 24 umschaltbar ist. Über dieses Verstärkungselement 60 wird dem Steuerspannungsanschluß 18 ein Abgleichsignal zugeführt, aus welchem sich mit dem genannten Verstärkungsfaktor die Sperrvorspannung am Steuerspannungsanschluß 18 ergibt. Der Verstärkungsfaktor des Verstärkungselementes 60 ist vorzugsweise zu jeder der Schwingfrequenzen derart gewählt, daß sich für den Abgleich des Oszillators 1 durch das Abgleichsignal auf alle einstellbaren Schwingfrequenzen Abgleichkennlinien mit wenigstens nahezu übereinstimmender Steilheit ergeben. Somit werden die durch die unterschiedlichen Steilheiten abweichenden "Übersetzungsverhältnisse" zwischen einem zugeführten Steuersignal und einer Änderung der Schwingfrequenz durch die unterschiedlichen Verstärkungsfaktoren korrigiert, so daß insgesamt stets wenigstens nahezu gleiche Kennlinie zwischen dem Steuersignal einerseits und den Änderungen der Schwingfrequenzen andererseits vorliegen. Eine mit dem Oszillator 1 aufgebaute, phasenverriegelte Regelschleife hat dann bei allen einstellbaren Schwingfrequenzen identisches Regelverhalten.

Im Ausführungsbeispiel nach der Figur ist das Verstärkungselement 60 mit seinem Ausgang 61 mit dem Steuerspannungsanschluß 18 verbunden. Einem Eingang 62 des Verstärkungselements 60 wird das Steuersignal zugeführt. Der Eingang 62 ist außerdem mit einem Anschluß 63 verbunden, über den dieses Steuersignal als AFC-Spannung anderen Signalverarbeitungsstufen zugeführt werden kann. Der Verstärkungsfaktor des Verstärkungselements 60 wird über einen Umschalteingang 64 auf den jeweils gewünschten Wert eingestellt. Der Umschalteingang 64 ist dazu mit einem Ausgang 65 der Stromsteuerschaltung 43 verbunden, der eine den Wirkverbindungen 41, 42 entsprechende Funktion aufweist. Damit werden die steuerbaren Stromquellen 27 bis 30 und das Verstärkungselement 60 von der Stromsteuerschaltung 43 simultan gesteuert bzw. umgeschaltet.

In einer Abwandlung dieser Ausgestaltung kann das Verstärkungselement 60 mit seinem Eingang 62 mit dem Steuerspannungsanschluß 18 und mit seinem Ausgang 61 mit dem Anschluß 63 verbunden sein. Das Steuersignal wird dann unmittelbar vom Steuerspannungsanschluß 18 als Sperrvorspannung auf die Kapazitätsdioden 15, 16 gegeben und andererseits dem Eingang 62 des Verstärkungselements 60 zugeführt. Nach einer durch den umschaltbaren Verstärkungsfaktor vorgegebenen Verstärkung, die wiederum die unterschiedlichen Steilheiten der Kennlinien zwischen der Sperrvorspannung und der Schwingfrequenz ausgleicht, gelangt das Steuersignal als AFC-Signal an den Anschluß 63.

## Patentansprüche

1. Oszillator (1) mit für eine erste Schwingfrequenz vorgesehenen ersten frequenzbestimmenden Elementen (13-16), mit wenigstens einem zweiten frequenzbestimmenden Element (23, 24), welches zum Einstellen des Oszillators (1) auf eine zweite Schwingfrequenz den ersten frequenzbestimmenden Elementen (13-16) über wenigstens eine Schaltdiode (25, 26) zuschaltbar ist, mit einer Speiseschaltung 27-44, 54), die wenigstens eine steuerbare Stromquelle (27-30) umfaßt, durch die die Schaltdiode (25, 26) gespeist wird und durch deren Umsteuern sie wahlweise in den leitenden oder gesperrten Zustand schaltbar ist, und mit einer den Oszillator (1) speisenden Stromquelle (4), **dadurch gekennzeichnet,**
**daß** die den Oszillator (1) speisende Stromquelle (4) von der Speiseschaltung (27-44, 54) zusammen mit dem Umsteuern der steuerbaren Stromquelle (27-30) auf einen Speisestrom umsteuerbar ist, der derart zu einem von der steuerbaren Stromquelle (27-30)abgegebenen Strom dimensioniert ist, daß Beeinflussungen des Arbeitspunktes und der Schwingungsamplitude des Oszillators (1) durch das Zuschalten des zweiten frequenzbestimmenden Elements wenigstens weitgehend ausgeglichen sind.

2. Oszillator (1) nach Anspruch 1, der eine Differenzverstärkerstufe umfaßt aus zwei Transistoren (2, 3), die mit ihren Emitteranschlüssen gemeinsam über die den Oszillator (1) speisende Stromquelle (4) mit Masse verbunden sind, wobei Kollektoranschlüsse der Transistoren (2, 3) über je einen Kollektorwiderstand (5, 6) mit einem Versorgungsspannungsanschluß (8) verbunden sind, **dadurch gekennzeichnet, daß** das Umsteuern der den Oszillator (1) speisenden Stromquelle (4) in der Weise erfolgt, daß in den Kollektorwiderständen (5, 6) in beiden Schaltzuständen der Schaltdiode (25, 26) übereinstimmende Ströme fließen.

3. Oszillator (1) nach Anspruch 1, **dadurch gekennzeichnet,**
**daß** die ersten frequenzbestimmenden Elemente (13-16) eine erste Kapazität (14-16) umfaßen, der eine zweite Kapazität (23, 24) als das zweite frequenzbestimmende Element (23, 24) über die Schaltdiode (25, 26) parallel schaltbar ist.

4. Oszillator (1) nach Anspruch 1, 2 oder 3, **dadurch gekennzeichnet, daß** die Speiseschaltung (27-44, 54) eine Treiberstufe (44) zum Steuern der steuerbaren Stromquelle(n) (27-30) umfaßt.

5. Oszillator nach einem der vorhergehenden Ansprüche, **gekennzeichnet durch**
ein Verstärkungselement (60), dessen Verstärkungsfaktor gemeinsam mit dem Zuschalten wenigstens eines der zweiten frequenzbestimmenden Elemente (23, 24) umschaltbar ist, und über das den ersten frequenzbestimmenden Elementen (14, 15, 16) ein Steuersignal zuführbar ist.

6. Oszillator nach Anspruch 5, **dadurch gekennzeichnet,**
**daß** der Verstärkungsfaktor zu jeder der Schwingfrequenzen derart gewählt ist, daß sich für die Steuerung des Oszillators durch das Steuersignal auf alle einstellbaren Schwingfrequenzen Steuerkennlinien mit wenigstens nahezu übereinstimmender Steilheit ergeben.

## Claims

1. An oscillator (1) having first frequency-determining elements (13-16) for providing a first oscillation frequency, at least a second frequency-determining element (23, 24) connectable to the first frequency-determining elements (13-16) via at least a switching diode (25, 26) for adjusting the oscillator (1) to a second oscillation frequency, said oscillator further comprising a supply circuit (27-44, 54) which comprises at least a controllable current source (27-30) by which the switching diode (25, 26) is fed and by whose switch-over it is optionally switchable to the conducting or the blocked state, and comprising a current source (4) feeding the oscillator (1), **characterized in that** the current source (4) feeding the oscillator (1) is switchable by means of the supply circuit (27-44, 54), jointly with the connection of the controllable current source (27-30) to a supply current which is dimensioned with respect to a current supplied by the controllable current source (27-30) in such a way that influences exercised on the operating point and the oscillation amplitude of the oscillator (1) are at least substantially compensated by the connection of the second frequency-determining element.

2. An oscillator as claimed in claim 1, comprising a differential amplifier stage consisting of two transistors (2, 3) whose emitters are jointly connected to ground via the current source (4) feeding the oscillator (1), and whose collectors are connected to a power supply terminal (8) via respective collector resistors (5, 6), **characterized in that** the current source (4) feeding the oscillator (1) is switched in such a way that corresponding currents flow in the collector resistors (5, 6) in both switching states of the switching diode (25, 26).

3. An oscillator as claimed in claim 1, **characterized in that** the first frequency-determining elements (13-16) comprise a first capacitance (14-16) with which a second capacitance (23, 24) as the second frequency-determining element (23, 24) is connectable in parallel via the switching diode (25, 26).

4. An oscillator as claimed in claim 1, 2, or 3, **characterized in that** the supply circuit (27-44, 54) comprises a driver stage (44) for controlling the controllable current source(s) (27-30).

5. An oscillator as claimed in any one of the preceding claims, **characterized by** an amplifier element (60) having a gain factor which is switchable, jointly with the connection of at least one of the second frequency-determining elements (23, 24), said amplifier element providing a control signal applicable to the first frequency-determining elements (14, 15, 16).

6. An oscillator as claimed in claim 5, **characterized in that** the gain factor for each of the oscillation frequencies is chosen to be such that control characteristics having at least substantially corresponding slopes are obtained for the control of the oscillator to all adjustable oscillation frequencies by the control signal.

## Revendications

1. Oscillateur (1) avec des premiers éléments (13-16) déterminant la fréquence prévus pour une première fréquence oscillante avec au moins un deuxième élément (23, 24) déterminant la fréquence qui peut être commuté pour le réglage de l'oscillateur (1) à une deuxième fréquence oscillante sur les premiers éléments (13-16) déterminant la fréquence par l'intermédiaire d'au moins une diode de commutation (25, 26), avec un circuit d'alimentation (27-44, 54) qui comprend au moins une source de courant commandable (27-30) par laquelle la diode de commutation (25, 25) est alimentée et par la commande de laquelle elle peut être montée au choix à l'état conducteur ou à l'état bloqué et avec une source de courant (4) alimentant l'oscillateur (1), **caractérisé en ce que** la source de courant (4) alimentant l'oscillateur (12) peut être commandée par le circuit d'alimentation (27 - 44, 54) en même temps que la commande de la source de courant (27 - 30) commandable sur un courant d'alimentation qui est dimensionné vers un courant délivré par la source de courant (27 - 30) commandable de telle sorte que les influences du point de travail et de l'amplitude d'oscillation de l'oscillateur (1) soient compensées, du moins en grande partie, par la commutation du deuxième élément déterminant la fréquence.

2. Oscillateur (1) selon la revendication 1 qui comprend un étage amplificateur différentiel composé de deux transistors (2, 3) qui sont reliés à la masse avec leurs bornes d'émetteur par l'intermédiaire de la source de courant (4) alimentant l'oscillateur (1), les bornes de collecteur des transistors (2, 3) étant respectivement reliées par l'intermédiaire d'une résistance de collecteur (5, 6) avec une borne de tension d'alimentation (8), **caractérisé en ce que** la commande de la source de courant (4) alimentant l'oscillateur (1) est effectuée de telle manière que les courants correspondant aux deux états de commutation de la diode de commutation (25, 26) circulent dans les résistances du collecteur (5, 6).

3. Oscillateur (1) selon la revendication 1, **caractérisé en ce**
**que** les premiers éléments déterminant la fréquence (13-16) comprennent une première capacité (14-16) qui peut être montée en parallèle comme deuxième élément déterminant la fréquence (23, 24) par l'intermédiaire des diodes de commutation (25, 26).

4. Oscillateur (1) selon la revendication 1, 2 ou 3, **caractérisé en ce**
**que** le circuit d'alimentation (27-44, 54) comprend un étage d'attaque (44) pour la commande de la ou des sources de courant commandables.

5. Oscillateur selon l'une des revendications précédentes, **caractérisé par** un élément amplificateur (60) dont le facteur d'amplification peut être commuté en même temps que la commutation d'au moins un des deuxièmes éléments déterminant la fréquence (23, 24) et par l'intermédiaire duquel un signal de commande peut être amené aux premiers éléments déterminant la fréquence (14, 15).

6. Oscillateur selon la revendication 5, **caractérisé en ce**
**que** le facteur d'amplification est sélectionné sur chacune des fréquences d'oscillation de telle sorte que des caractéristiques de commande avec une pente concordante, du moins en grande partie, soient obtenues pour la commande de l'oscillateur par le signal de commande sur toutes les fréquences d'oscillation réglables.
